# EUROPEAN PATENT SPECIFICATION

(11) **EP 4 246 568 B1**
(45) Date of publication and mention of the grant of the patent: **29.07.2026**
(21) Application number: 21896197.7
(22) Date of filing: 17.05.2021
(51) Int. Cl.: H10W 42/20, H05K 1/185, H10W 70/60, H10W 70/65, H10W 90/00, H05K 1/02, H05K 3/46, H10W 76/40, H10W 42/00

(54) **PACKAGE SUBSTRATE AND COMMUNICATION DEVICE**
VERPACKUNGSSUBSTRAT UND KOMMUNIKATIONSVORRICHTUNG
SUBSTRAT D'EMBALLAGE ET DISPOSITIF DE COMMUNICATION

(30) Priority: 30.11.2020 CN 202011377915
(43) Date of publication of application: 20.09.2023
(73) Proprietor: Huawei Technologies Co., Ltd., Shenzhen, Guangdong 518129 (CN)
(72) Inventor: KANG, Chen, Shenzhen, Guangdong 518129 (CN); SHEN, Chao, Shenzhen, Guangdong 518129 (CN); LIAO, Xiaojing, Shenzhen, Guangdong 518129 (CN); WANG, Junhe, Shenzhen, Guangdong 518129 (CN)
(74) Representative: Epping - Hermann - Fischer
(86) International application number: PCT/CN2021/094104
(87) International publication number: WO 2022/110682

(56) References cited:
- WO-A1-2011/058879
- WO-A1-2019/179184
- CN-A- 102 479 763
- CN-A- 104 321 868
- CN-A- 104 576 575
- CN-A- 106 471 619
- CN-A- 110 021 566
- CN-Y- 201 110 859
- JP-A- 2016 219 798
- US-A1- 2010 308 452
- US-A1- 2010 320 594
- US-A1- 2011 176 284
- US-A1- 2012 081 864

## Description

This disclosure claims priority to Chinese Patent Application No. 202011377915.6, filed with the China National Intellectual Property Administration on November 30, 2020, and entitled "PACKAGE SUBSTRATE AND COMMUNICATION DEVICE".

### TECHNICAL FIELD

This disclosure relates to the field of packaging technologies, and in particular, to a package substrate and a communication device.

### BACKGROUND

With development of electronic products towards miniaturization, portability, and multifunction, a chip-embedded package substrate has become a research hotspot in the field of electronic component packaging technologies. After an existing chip is embedded in a substrate, external water vapor easily enters the package substrate from a peripheral side of the package substrate; and consequently the package substrate is faulty due to moisture absorption. Document CN 104 576 575 A discloses a semiconductor packaging piece. The semiconductor packaging piece comprises a substrate, a first conducting post and a chip, the substrate is provided with an upper surface and a lower surface which are opposite to each other; a through hole penetrates through the substrate from the upper surface to the lower surface. The first conducting post penetrates through the substrate from the upper surface to the lower surface and is exposed to the inner side surface of the through hole. The chip is embedded in the through hole. Document US 2011/176284 A1 describes a multilayer printed circuit board, wherein, on a resin-insulating layer that houses a semiconductor element, another resin-insulating layer and a conductor circuit are formed with conductor circuits electrically connected through a via hole, wherein an electromagnetic shielding layer is formed on a resin-insulating layer surrounding a concave portion for housing a semiconductor element or on the inner wall surface of the concave portion, and the semiconductor element is embedded in the concave portion. Document US 2010/308452 A1 discloses a method, in which the semiconductor components forming part of an electronic circuit, or at least some of them, are embedded in a base, such as a circuit board, during the manufacture of the base, when part of the base structure is, as it were, manufactured around the semiconductor components. Through-holes for the semiconductor components are made in the base, in such a way that the holes extend between the first and second surface of the base. After the making of the holes, a polymer film is spread over the second surface of the base structure, in such a way that the polymer film also covers the through-holes made for the semiconductor components from the side of the second surface of the base structure. Before the hardening, or after the partial hardening of the polymer film, the semiconductor components are placed in the holes made in the base, from the direction of the first surface of the base. The semiconductor components are pressed against the polymer film in such a way that they adhere to the polymer film. After this, the final hardening of the polymer film is carried out. Document US 2010/320594 A1 describes a semiconductor device which includes a reinforcement plate having an accommodating hole and a through hole extending from a first surface to a second surface, a semiconductor chip including a chip core and a pad formed on a pad surface of the chip core. The semiconductor chip is disposed in the accommodating hole with the pad surface flush with the first surface, wherein the chip core has substantially the same thickness as the reinforcement plate and includes a semiconductor substrate, a through-hole electrode disposed in the through hole, resin sealing the semiconductor chip and the reinforcement plate, an interconnection pattern disposed on the first-surface side of the reinforcement plate to connect between the through-hole electrode and the pad. An interconnection pattern is disposed on the second-surface side of the reinforcement plate to be connected to the through-hole electrode, wherein the reinforcement plate is made of the same material as the semiconductor substrate. Document WO 2011/058879 A1 describes is a substrate with a built-in functional element, wherein via-hole density, especially via-hole density between wiring layers around the periphery of the functional element can be improved. The substrate with the built-in functional element comprises the functional element; and a reinforcement layer that has a plurality of via holes, and that is comprised of a first insulation material having the functional element buried therein. The substrate with the built-in functional element has at least one via hole, among the via holes that face the functional element in proximity, made to be a deformed via hole having a planar side face at the side facing a side face of the functional element. Document JP 2016 219798 A relates to an electronic component package which includes a frame containing a metal or ceramic based material and having a through-hole, an electronic component disposed in the through-hole, an insulating part at least covering upper portions of the frame and the electronic component, a bonding part at least partially disposed between the frame and the insulating part, and a redistribution part disposed at one side of the frame and the electronic component. Document WO 2019/179184 A1 relates to the technical field of electronic packages, discloses a package structure and a manufacturing method therefor, and an electronic device, and solves the problem that in a POP structure, a lower package structure is thick. The package structure comprises: a first redistribution layer having a first surface and a second surface which are provided opposite to each other, the second surface of the first redistribution layer being fixedly connected to a printed circuit board; a substrate, one side of the substrate being provided with a depressed part, the substrate being fixed onto the first surface of the first redistribution layer, and the depressed part and the first redistribution layer constituting a receiving space for receiving a target chip; and the target chip received in the receiving space and electrically connected to the first surface of the first redistribution layer.

### SUMMARY

An embodiment of this disclosure provides a package substrate and a communication device, to prevent external water vapor from entering the package substrate from a peripheral side of the package substrate, and effectively prevent a failure of the package substrate due to moisture absorption. The present invention is set out by the set of appended claims. In the following, parts of the description and drawing referring to implementations or examples, which are not covered by the claims are not presented as embodiments of the invention, but as illustrative examples useful for understanding the invention. The embodiments of the present invention are provided by the appended claims.

This disclosure provides a package substrate, including:
a package body, where the package body includes a top surface and a bottom surface that are oppositely disposed;
a first circuit layer and a second circuit layer, where the first circuit layer is disposed on the top surface of the package body, and the second circuit layer is disposed on the bottom surface of the package body;
an electronic component, where the electronic component is packaged inside the package body; and
a moisture-proof structure, where the moisture-proof structure is provided to the package body and is connected between the first circuit layer and the second circuit layer, and the moisture-proof structure surrounds the electronic component.

It may be understood that the package body made of a package material has specific moisture absorption performance, and may absorb moisture in an external environment. However, the electronic component is in a structure packaged in the package body, and at a joint between a pin of the electronic component and the package body, a small gap is easily generated. After moisture is absorbed, an electric-leakage path is easily formed at these small gaps, and consequently, the package substrate is faulty when powered on for use. Therefore, the moisture-proof structure is disposed, and the moisture-proof structure can be disposed around a periphery of the electronic component in a surrounding structure, so that the electronic component can be within a protection range of the moisture-proof structure. In other words, the electronic component is located inside the moisture-proof structure, and can have good moisture-proof performance due to protection of the moisture-proof structure. This helps better ensure electrical performance of the electronic component. In addition, the surrounding structure may maximize a feature of blocking external moisture in various directions, and maximizes a role of moisture-proof protection. In addition, because the moisture-proof structure is further connected between the first circuit layer and the second circuit layer, a height of the moisture-proof structure can completely occupy a height interval between the first circuit layer and the second circuit layer, that is, the height of the moisture-proof structure can completely adapt to the height interval of the package body, to implement a tight blocking function, and minimize a possibility that the external moisture may pass through the moisture-proof structure and further penetrate into the package body.

In other words, the moisture-proof structure is disposed, so that the inside of the moisture-proof structure is defined as an area in which moisture cannot enter, and even if the moisture converges from the outside of the moisture-proof structure to a position of the moisture-proof structure, the moisture cannot pass through the moisture-proof structure to enter the defined area protected by the moisture-proof structure due to a moisture-proof feature of the moisture-proof structure. This effectively prevents the external moisture from entering the package substrate from a side edge of the package substrate, and prevent a failure of the package substrate due to moisture absorption, and the package substrate has good moisture-proof performance. In addition, the package substrate can have a good environment adaptability as a whole, and can cope with complex and changeable environment changes, so that even in a damp and hot external environment, the package substrate can have good moisture-proof performance, to effectively isolate external moisture, dust, and the like, so as to have high reliability and high practicability.

In a possible implementation, the moisture-proof structure is a continuously-extending closed ring structure.

In this way, the moisture-proof structure can form a continuous surrounding architecture, and the continuous surrounding architecture can maximize sealing performance of the moisture-proof structure, so that external moisture is hermetically blocked outside the continuous surrounding architecture. This helps ensure overall electrical performance of the package substrate.

Alternatively, the moisture-proof structure includes a plurality of moisture-proof substructures, the plurality of moisture-proof substructures are distributed in a staggered manner, and two adjacent moisture-proof substructures at least partially overlap.

For example, the plurality of moisture-proof substructures may be arranged in a four-side staggered form. It should be understood that, that two adjacent moisture-proof substructures located on a same side at least partially overlap may be understood as that, on a reference surface parallel to the two adjacent moisture-proof substructures, orthographic projection that is of one moisture-proof substructure and that is on the reference surface at least partially falls within a range of orthographic projection that is of the other moisture-proof substructure and that is on the reference surface. That two adjacent moisture-proof substructures at least partially overlap may not only mean that the two adjacent moisture-proof substructures located on a same side at least partially overlap, but also may mean that two adjacent moisture-proof substructures located at a corner at least partially overlap.

In this way, the plurality of moisture-proof substructures can be in a discontinuous surrounding structure, and two adjacent moisture-proof substructures do not have a direct connection relationship, and can be in an arrangement form in which positions are staggered. In addition, the two adjacent moisture-proof substructures at least partially overlap, so that an outer contour surrounded by the plurality of moisture-proof substructures is generally in an annular surrounding form, that is, the plurality of moisture-proof substructures can be in a staggered blocking form. This helps minimize a possibility that the external moisture penetrates to cause a failure of the package substrate due to moisture absorption.

It should be noted that an arrangement form of the plurality of moisture-proof substructures is not limited to the foregoing described possibilities. The arrangement form may alternatively be that one side is continuous and three sides are staggered, or may be that two sides are continuous and two sides are staggered, or may be that three sides are continuous and one side is staggered. Staggered and continuous arrangement and combination forms are not listed herein. However, it should be understood that this disclosure is not limited thereto.

The moisture-proof structure is embedded in the package body. It should be understood that, that the moisture-proof structure is embedded in the package body may be understood as that the moisture-proof structure is completely disposed inside the package body. That is, the electronic component is inside the moisture-proof structure, and a circle of the package material of the package body is still disposed outside the moisture-proof structure. That is, the moisture-proof structure is still at a specific distance from the peripheral side surface of the package body.

In this way, the moisture-proof structure is completely disposed inside the package body, so that even if moisture aggregates from the package body disposed outside the moisture-proof structure to the position of the moisture-proof structure, the moisture cannot pass through the moisture-proof structure to enter the small gap between the package body and the pin of the electronic component due to the moisture-proof feature of the moisture-proof structure. This can effectively prevent a failure of the package substrate due to moisture absorption, and the package substrate has good moisture-proof performance.

Alternatively but not according to the invention, at least a part of the moisture-proof structure is exposed on a side portion of the package body.

Therefore, the moisture-proof structure can hermetically block moisture of an external environment outside the package body, and further prevent the moisture of the external environment from entering the package body. This helps ensure electrical performance of the package substrate.

The package body includes a frame and a package layer, the frame is provided with a cavity, the electronic component is accommodated in the cavity, the frame further includes a first surface and a second surface that are oppositely disposed, the package layer is filled in the cavity, to wrap the electronic component and cover the first surface and the second surface, and surfaces of the package layer that are away from the frame form the top surface and the bottom surface.

The moisture-proof structure includes a frame blocking wall and a package blocking wall, the frame blocking wall is disposed in the frame, and the package blocking wall is disposed in the package layer.

According to one aspect of the invention, the package blocking wall is connected between the frame blocking wall and the first circuit layer and connected between the frame blocking wall and the second circuit layer, and orthographic projection that is of the package blocking wall and that is on the first surface at least partially falls within a range of orthographic projection that is of the frame blocking wall and that is on the first surface.

According to another aspect of the invention, the package blocking wall is connected between the first surface and the first circuit layer and connected between the second surface and the second circuit layer, and the package blocking wall and the frame blocking are disposed in a staggered manner.

According to a further aspect of the invention, the package blocking wall is connected between the first surface and the first circuit layer and connected between the second surface and the second circuit layer, and the package blocking wall is adjacent to the frame blocking wall.

It may be understood that the frame blocking wall and the package blocking wall jointly form the moisture-proof structure. Because the moisture-proof structure has only a moisture-proof function but does not have a function of electrically connecting the first circuit layer and the second circuit layer, specific positions of the frame blocking wall and the package blocking wall may be diversified. This disposition can further increase a degree of freedom of manufacturing the moisture-proof structure, and help reduce a difficulty of manufacturing the package substrate.

Therefore, on one hand, it can be ensured that the moisture-proof structure can be hermetically disposed between the first circuit layer and the second circuit layer, to minimize a possibility of a problem that moisture outside the package substrate penetrates from a loose connection position because the moisture-proof structure is not hermetically connected to the first circuit layer and the second circuit layer, resulting in a failure of the package substrate due to moisture absorption. On the other hand, because the moisture-proof structure is disposed on each side of the side portion of the package body, moisture from various directions can be effectively blocked, to further improve moisture-proof performance of the package substrate.

In a possible implementation, the electronic component is a chip, the package substrate further includes a signal shielding structure disposed on the frame, and the signal shielding structure is located between the package blocking wall and the cavity and surrounds the cavity.

It may be understood that, the signal shielding structure can be disposed, to avoid signal interference, ensure precision of signal transmission of the chip, and improve stability of the chip during working, so as to minimize a possibility of an exception of the package substrate during working, and fully ensure stability of the package substrate during working.

In a possible implementation, the signal shielding structure is a continuously-extending closed ring structure.

In this way, the signal shielding structure can be disposed around the periphery of the cavity in which the chip is disposed, to form a continuous surrounding architecture. The continuous surrounding architecture can maximize sealing performance of the signal shielding structure, and play a good role of shielding signal interference. This helps ensure overall electrical performance of the package substrate.

Alternatively, the signal shielding structure includes a shielding blocking wall and a shielding top cover, the shielding blocking wall is disposed around a periphery of the cavity, and at least a part of the shielding top cover is located in the cavity and is connected to one end of the shielding blocking wall.

For example, the plurality of signal shielding substructures may be in a four-side staggered form. It should be understood that, that two adjacent signal shielding substructures located on a same side at least partially overlap may be understood as that, on a reference surface parallel to the two adjacent signal shielding substructures, orthographic projection that is of one signal shielding substructure and that is on the reference surface at least partially falls within a range of orthographic projection that is of the other signal shielding substructure and that is on the reference surface. That two adjacent signal shielding substructures at least partially overlap may not only mean that the two adjacent signal shielding substructures located on a same side at least partially overlap, but also may mean that two adjacent signal shielding substructures located at a corner at least partially overlap.

In this way, the plurality of signal shielding substructures can be disposed around the periphery of the cavity in which the chip is disposed, to form the discontinuous surrounding structure, and two adjacent signal shielding substructures do not have a direct connection relationship, and can be in an arrangement form in which positions are staggered. In addition, the two adjacent signal shielding substructures at least partially overlap, so that an outer contour surrounded by the plurality of signal shielding substructures is generally in an annular surrounding form, that is, the plurality of signal shielding substructures can be in a staggered blocking form. This helps minimize a possibility that external moisture penetrates to cause a failure of the package substrate due to moisture absorption.

It should be noted that an arrangement form of the plurality of signal shielding substructures is not limited to the foregoing described possibilities. The arrangement form may alternatively be that one side is continuous and three sides are staggered, or may be that two sides are continuous and two sides are staggered, or may be that three sides are continuous and one side is staggered. Staggered and continuous arrangement and combination forms are not listed herein. However, it should be understood that this disclosure is not limited thereto.

In a possible implementation, the package substrate further includes a conductive connecting column disposed in the frame, and the frame further includes a peripheral side surface connecting the first surface and the second surface.

The conductive connecting column is located outside the cavity, and is electrically connected between the first circuit layer and the second circuit layer, and a distance between the conductive connecting column and the peripheral side surface of the frame is greater than a distance between the moisture-proof structure and the peripheral side surface of the frame.

It may be understood that, the conductive connecting column can form an electrical connection relationship between the first circuit layer and the second circuit layer, so that the electronic component can implement double-sided interconnection by using the conductive connecting column.

In this way, the conductive connecting column is disposed, so that double-sided interconnection of the electronic component can be implemented. This helps shorten a cabling distance and maximize a short-distance transmission path, can effectively implement higher power with a smaller area or volume, and can improve an overall power density, arrangement density, and integration degree of the package substrate.

In a possible implementation, the package body further includes a metal layer, the metal layer is embedded in a middle position in a thickness direction of the frame, and the metal layer extends along a direction parallel to the package substrate.

In this way, one metal layer is added at the middle position in the thickness direction of the frame. Due to a structure feature of the metal layer, the frame has good heat dissipation performance as a whole, to significantly improve overall heat dissipation performance and stability of the package substrate, and mechanical strength of the frame may be increased, so that the frame does not easily deform due to an external force, to improve the mechanical strength of the package substrate.

In a possible implementation, the metal layer intersects with the conductive connecting column, and the metal layer is electrically connected to the conductive connecting column.

It may be understood that the metal layer can be arranged as a circuit layer and provide specific cabling design. In addition, because the metal layer is connected to the conductive connecting column that can implement a double-sided interconnection function, the metal layer may be manufactured as an interconnection circuit according to an actual design requirement, and a signal shield layer between an upper surface and a lower surface (the first surface and the second surface) is formed. In this way, the metal layer can improve the heat dissipation performance, improve the mechanical strength, and provide the cabling design, and has diversified performance, high flexibility, and a wide application scope.

It should be noted that, when the metal layer is disposed as a circuit layer, the metal layer may be discontinuously-extending layer structure design, namely, discontinuous layer structure design. The discontinuous structure design can reserve a specific loop for double-sided interconnection, to ensure reliability of double-sided interconnection.

In a possible implementation, the package substrate further includes a first solder mask layer and a second solder mask layer.

The first solder mask layer is disposed on a surface that is of the first circuit layer and that is away from the package body, and covers a part of the top surface that is of the package body and that is not covered by the first circuit layer, the first solder mask layer is provided with a first opening, and the first opening exposes a part of the first circuit layer, so that the exposed part of the first circuit layer forms a first pad of the package substrate.

The second solder mask layer is disposed on a surface that is of the second circuit layer and that is away from the package body, and covers a part of the bottom surface that is of the package body and that is not covered by the second circuit layer, the second solder mask layer is provided with a second opening, and the second opening exposes a part of the second circuit layer, so that the exposed part of the second circuit layer forms a second pad of the package substrate.

The first circuit layer and the second circuit layer are disposed, so that the first circuit layer can shield a part of the top surface of the package body, and the second circuit layer can shield a part of the bottom surface of the package body, to block the external moisture from entering the package body. In addition, both sides (the top surface and the bottom surface) of the package body each have a circuit layer having an electrical connection function. This can provide a good foundation for double-sided interconnection of the electronic component packaged in the package body, and facilitate implementation of a shortest interconnection path and a thin package of the package substrate in a limited space layout, and the package substrate has high practicability and high reliability.

The first solder mask layer and the second solder mask layer are disposed, the first opening is provided on the first solder mask layer, and the second opening is provided on the second solder mask layer, so that a circuit and a substrate that need to be soldered in the package substrate can be exposed, to form the first pad and the second pad, and a circuit and a substrate that do not need to be soldered in the package substrate can be shielded due to a solder mask function of the first solder mask layer and the second solder mask layer. On one hand, solder waste can be avoided, and an electrical short circuit problem caused by solder bridging in a soldering process can be avoided. This facilitates long-term protection of a formed circuit pattern. On the other hand, the first solder mask layer and the second solder mask layer have good insulation performance, so that problems such as insulation deterioration and corrosion caused by external environmental factors such as dust and water vapor can be prevented, and a high density of the circuit can be implemented.

Based on the foregoing descriptions, it should be understood that the top surface of the package body may be covered by the first circuit layer and the first solder mask layer together, to prevent the external moisture. The bottom surface of the package body may also be covered by the second circuit layer and the second solder mask layer together, to prevent the external moisture. In this way, both the top surface and the bottom surface of the package substrate can have good moisture-proof performance because the top surface and the bottom surface can effectively block the external moisture.

This disclosure further provides a communication device. The communication device includes a circuit board and the foregoing package substrate, and the package substrate is disposed on the circuit board.

### BRIEF DESCRIPTION OF DRAWINGS

FIG. 1 is a simple schematic diagram of a communication device according to an example of this disclosure;
FIG. 2 is a schematic diagram of a first profile of a package substrate according to an example of this disclosure but not according to the invention;
FIG. 3 is a schematic diagram of a second profile of a package substrate according to an example of this disclosure but not according to the invention;
FIG. 4 is a schematic diagram of a third profile of a package substrate according to an example of this disclosure but not according to the invention;
FIG. 5 is a schematic diagram of a fourth profile of a package substrate according to an example of this disclosure;
FIG. 6 is a schematic diagram of a fifth profile of a package substrate according to an example of this disclosure;
FIG. 7 is a schematic diagram of a sixth profile of a package substrate according to an example of this disclosure;
FIG. 8 is a schematic diagram of a profile of a moisture-proof structure of a package substrate according to an example of this disclosure;
FIG. 9 is a schematic diagram of another profile of a moisture-proof structure of a package substrate according to an example of this disclosure;
FIG. 10 is a schematic diagram of still another profile of a moisture-proof structure of a package substrate according to an example of this disclosure;
FIG. 11 is a schematic diagram of yet another profile of a moisture-proof structure of a package substrate according to an example of this disclosure;
FIG. 12 is a schematic diagram of a fifth profile of a moisture-proof structure of a package substrate according to an example of this disclosure;
FIG. 13 is a schematic diagram of a seventh profile of a package substrate according to an example of this disclosure;
FIG. 14 is a schematic diagram of an eighth profile of a package substrate according to an example of this disclosure;
FIG. 15 is a schematic diagram of a profile of a signal shielding structure of a package substrate according to an example of this disclosure; and
FIG. 16 is a schematic diagram of another profile of a signal shielding structure of a package substrate according to an example of this disclosure.

### DETAILED DESCRIPTION

The following clearly describes specific implementations of this disclosure with reference to the accompanying drawings.

An example of this disclosure provides a communication device 200. The communication device 200 may be, but is not limited to, a device such as a power supply module, a communication signal transmission base station, or an outdoor network switch device.

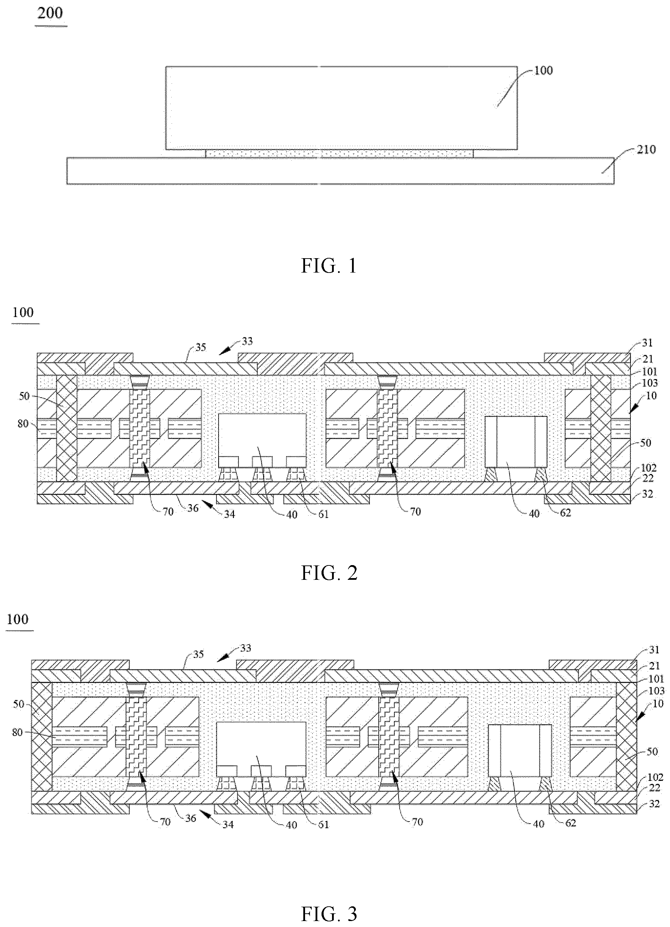

As shown in FIG. 1, the communication device 200 includes a circuit board 210 and a package substrate 100. The circuit board 210 may be understood as a carrier of the package substrate 100. The circuit board 210 can carry the package substrate 100 and be assembled with the package substrate 100, to implement electrical interconnection to the package substrate 100. The package substrate 100 may be understood as a carrier for packaging a semiconductor chip, and may provide functions such as electrical connection, protection, support, heat dissipation, and assembly to electronic components such as a chip and a resistor-capacitor component.

It should be noted that FIG. 1 is merely intended to schematically describe a connection relationship between the circuit board 210 and the package substrate 100, and is not intended to specifically limit connection positions, specific structures, and quantities of devices. A structure shown in this example of this disclosure does not constitute a specific limitation on the communication device 200. In some other examples of this disclosure, the communication device 200 may include more or fewer components than those shown in the figure, or combine some components, or split some components, or have different component arrangements. The components shown in the figure may be implemented through hardware, software, or a combination of software and hardware.

In this example of this disclosure, the package substrate 100 is specifically described by using an embedded substrate as an example. It may be understood that, the embedded substrate may be understood as a packaging structure in which a chip is mounted inside the substrate, then the chip is packaged on both sides by using a package material, and then double-side interconnection is implemented by using a related process.

It may be understood that there may be a small gap between the package material and a pin of an electronic component such as a chip or a resistor-capacitor component packaged in the package material. In addition, the package material has specific moisture absorbing performance, and this means that the package material has a capability of absorbing external water vapor/moisture). Therefore, when external moisture enters the package substrate 100, an electric-leakage path is easily formed at the small gap, and the electric-leakage path causes the package substrate 100 to fail when the package substrate 100 is powered on for use. However, for the entire package substrate 100, the external moisture is difficult to enter the package substrate 100 from an upper surface and a lower surface of the package substrate 100, and is more likely to enter the package substrate 100 from a side surface of the package substrate 100. That is, moisture-proof performance of the side surface of the package substrate 100 is poorer. The upper surface and the lower surface of the package substrate 100 may be understood as outer surfaces of the package substrate 100 that are parallel to a plane when the package substrate 100 is placed on the plane. The side surface of the package substrate 100 may be understood as an outer surface that is of the package substrate 100 and that is perpendicular to a reference surface when the package substrate 100 is placed on the reference surface. Based on the foregoing descriptions, corresponding structure design needs to be performed on the package substrate 100, to ensure that the entire package substrate 100 can have better moisture-proof performance.

In this way, the package substrate 100 provided in this example of this disclosure can prevent the external moisture from entering the package substrate 100 from a peripheral side of the package substrate 100, to effectively prevent a failure of the package substrate 100 due to moisture absorption, and ensure high reliability and high stability of a circuit system of the package substrate 100 in a normal working process. Details are further described below.

As shown in FIG. 2 to FIG. 7, the package substrate 100 includes a package body 10, a first circuit layer 21, a first solder mask layer 31, a first connection column 61, a second circuit layer 22, a second solder mask layer 32, a second connection column 62, an electronic component 40, a moisture-proof structure 50, a conductive connecting column 70, and a metal layer 80.

The package body 10 includes a top surface 101, a bottom surface 102, and a peripheral side surface 103 connected between the top surface 101 and the bottom surface 102. The top surface 101, the bottom surface 102, and the peripheral side surface 103 of the package body 10 are connected, to jointly form an appearance structure of the package body 10. It may be understood that, the package body 10 is placed on a reference surface, the top surface 101 of the package body 10 is a surface away from the reference surface, the bottom surface 102 of the package body 10 is a surface attached to the reference surface, and the peripheral side surface 103 of the package body 10 is a surface perpendicular to the reference surface.

The top surface 101, the bottom surface 102, and the peripheral side surface 103 of the package body 10 are the appearance structure of the package body 10 that may be exposed outside. Therefore, to prevent external moisture from entering the package body 10 from respective positions of the top surface 101, the bottom surface 102, and the peripheral side surface 103, and affecting electrical performance of the inside of the package body 10, corresponding structure design is required, to block moisture that may enter the package body 10 from the top surface 101, the bottom surface 102, and the peripheral side surface 103 of the package body 10, and implement good moisture-proof performance of the package body 10.

The first circuit layer 21 is disposed on the top surface 101 of the package body 10, and the second circuit layer 22 is disposed on the bottom surface 102 of the package body 10. It may be understood that pattern design of the first circuit layer 21 may be set according to a requirement of the electronic component 40 packaged by the package body 10, and pattern design of the second circuit layer 22 may also be set according to the requirement of the electronic component 40 packaged by the package body 10. In addition, there may be a difference between the pattern design of the first circuit layer 21 and the pattern design of the second circuit layer 22. In other words, the pattern design of the first circuit layer 21 and the pattern design of the second circuit layer 22 may be different. This is not strictly limited in this example of this disclosure. For example, materials of the first circuit layer 21 and the second circuit layer 22 may be copper.

The first circuit layer 21 and the second circuit layer 22 are disposed, so that the first circuit layer 21 can shield a part of the top surface 101 of the package body 10, and the second circuit layer 22 can shield a part of the bottom surface 102 of the package body 10, to block the external moisture from entering the package body 10. In addition, both sides (the top surface 101 and the bottom surface 102) of the package body 10 each have a circuit layer having an electrical connection function. This can provide a good foundation for double-side interconnection of the electronic component 40 packaged in the package body 10, and facilitate implementation of a shortest interconnection path and a thin package of the package substrate 100 in a limited space layout, so that the package substrate 100 has high practicability and high reliability.

The first solder mask layer 31 is disposed on a surface that is of the first circuit layer 21 and that is away from the package body 10, and covers a part of the top surface 101 that is of the package body 10 and that is not covered by the first circuit layer 21. The first solder mask layer 31 is provided with a first opening 33, and the first opening 33 exposes a part of the first circuit layer 21, so that the exposed part of the first circuit layer 21 forms a first pad 35 of the package substrate 100.

The first solder mask layer 31 is disposed, and the first opening 33 is provided on the first solder mask layer 31, so that a circuit and a substrate that need to be soldered in the package substrate 100 can be exposed, to form the first pad 35, and a circuit and a substrate that do not need to be soldered in the package substrate 100 can be shielded due to a solder mask function of the first solder mask layer 31. On one hand, solder waste can be avoided, and an electrical short circuit problem caused by solder bridging in a soldering process can be avoided. This facilitates long-time protection of a formed circuit pattern. On the other hand, the first solder mask layer 31 has good insulation performance, so that problems such as insulation deterioration and corrosion caused by external environmental factors such as dust and water vapor can be prevented, and high density of the circuit can be implemented.

It should be noted that a quantity of first openings 33, and a shape and a size of the first opening 33 may be designed based on an actual soldering status of the package substrate 100. The quantity may be one, two, or more, and the shape may be a rectangle, a circle, a polygon, or the like. This is not strictly limited in this example of this disclosure. For example, when there are a plurality of first openings 33, there are also a plurality of formed first pads 35; and sizes of the plurality of first pads 35 may be different, and shapes of the plurality of first pads 35 may be one or a combination of a rectangle, a circle, or a polygon.

The second solder mask layer 32 is disposed on a surface that is of the second circuit layer 22 and that is away from the package body 10, and covers a part of the top surface 101 that is of the package body 10 and that is not covered by the second circuit layer 22. The second solder mask layer 32 is provided with a second opening 34, and the second opening 34 exposes a part of the second circuit layer 22, so that the exposed part of the second circuit layer 22 forms a second pad 36 of the package substrate 100.

The second solder mask layer 32 is disposed, and the second opening 34 is provided on the second solder mask layer 32, so that a circuit and a substrate that need to be soldered in the package substrate 100 can be exposed, to form the second pad 36, and a circuit and a substrate that do not need to be soldered in the package substrate 100 can be shielded due to a solder mask function of the second solder mask layer 32. On one hand, solder waste can be avoided, and an electrical short circuit problem caused by solder bridging in a soldering process can be avoided. This facilitates long-time protection of a formed circuit pattern. On the other hand, the second solder mask layer 32 has good insulation performance, so that problems such as insulation deterioration and corrosion caused by external environmental factors such as dust and water vapor can be prevented, and high density of the circuit can be implemented.

It should be noted that a quantity of second openings 34, and a shape and a size of the second opening 34 may be designed based on the actual soldering status of the package substrate 100. The quantity may be one, two, or more, and the shape may be a rectangle, a circle, a polygon, or the like. This is not strictly limited in this example of this disclosure. For example, when there are a plurality of second openings 34, there are also a plurality of formed second pads 36; and sizes of the plurality of second pads 36 may be different, and shapes of the plurality of second pads 36 may be one or a combination of a rectangle, a circle, or a polygon.

Based on the foregoing descriptions, it should be understood that the top surface 101 of the package body 10 may be covered by the first circuit layer 21 and the first solder mask layer 31 together, to prevent the external moisture. The bottom surface 102 of the package body 10 may also be covered by the second circuit layer 22 and the second solder mask layer 32 together, to prevent the external moisture. In this way, both the top surface 101 and the bottom surface 102 of the package substrate 100 can have good moisture-proof performance because the top surface 101 and the bottom surface 102 can effectively block the external moisture.

As shown in FIG. 2, FIG. 3, and FIG. 4, the electronic component 40 is packaged inside the package body 10, the moisture-proof structure 50 is disposed inside the package body 10 and is connected between the first circuit layer 21 and the second circuit layer 22, and the moisture-proof structure 50 surrounds the electronic component 40. That is, a distance between the moisture-proof structure 50 and the peripheral side surface 103 of the package body 10 is less than a distance between the electronic component 40 and the peripheral side surface 103 of the package body 10. The moisture-proof structure 50 can be in a surrounding structure that surrounds the electronic component 40 and is disposed in the package body 10, one end of the moisture-proof structure 50 is connected to the first circuit layer 21, and the other end of the moisture-proof structure 50 is connected to the second circuit layer 22.

For example, the package body 10 may be made of a resin material having specific moisture absorption performance, and the moisture-proof structure 50 may be made of a copper material.

It may be understood that the package body 10 made of the package material has specific moisture absorption performance, and may absorb moisture in an external environment. However, the electronic component 40 is a structure packaged in the package body 10, and at a joint between a pin of the electronic component 40 and the package body 10, a small gap is easily generated. After moisture is absorbed, an electric-leakage path is easily formed at these small gaps, and consequently, the package substrate 100 is faulty when the package substrate 100 is powered on for use. Therefore, the moisture-proof structure 50 is disposed, and the moisture-proof structure 50 can be disposed around a periphery of the electronic component 40 in a surrounding structure, so that the electronic component 40 can be within a protection range of the moisture-proof structure 50. In other words, the electronic component 40 is located inside the moisture-proof structure 50, and can have good moisture-proof performance due to protection of the moisture-proof structure 50. This helps better ensure electrical performance of the electronic component 40. In addition, the surrounding structure may maximize a feature of blocking external moisture in various directions, and maximizes a role of moisture-proof protection. In addition, because the moisture-proof structure 50 is further connected between the first circuit layer 21 and the second circuit layer 22, a height of the moisture-proof structure 50 can completely occupy a height interval between the first circuit layer 21 and the second circuit layer 22, that is, the height of the moisture-proof structure 50 can completely adapt to the height interval of the package body 10, to implement a tight blocking function, and minimize a possibility that the external moisture may pass through the moisture-proof structure 50 and further penetrate into the package body 10.

In other words, the moisture-proof structure 50 is disposed, so that the inside of the moisture-proof structure 50 is defined as an area in which moisture cannot enter, and even if the moisture converges from the outside of the moisture-proof structure 50 to a position of the moisture-proof structure 50, the moisture cannot pass through the moisture-proof structure 50 to enter the defined area protected by the moisture-proof structure 50 due to a moisture-proof feature of the moisture-proof structure 50. This can effectively prevent the external moisture from entering the package substrate 100 from a side edge of the package substrate 100, and prevent a failure of the package substrate 100 due to moisture absorption, and the package substrate 100 has good moisture-proof performance. In addition, the package substrate 100 can have a good environment adaptability as a whole, and can cope with complex and changeable environment changes, so that even in a damp and hot external environment, the package substrate 100 can have good moisture-proof performance, to effectively isolate external moisture, dust, and the like, so as to have high reliability and high practicability.

Because the moisture-proof structure 50 needs to be disposed in the package body 10 and surrounds the electronic component 40, positions for disposing the moisture-proof structure 50 may be diversified. The following describes possibilities of the position of the moisture-proof structure 50 with reference to accompanying drawings.

The moisture-proof structure 50 is embedded in the package body 10. It should be understood that, that the moisture-proof structure 50 is embedded in the package body 10 may be understood as that the moisture-proof structure 50 is completely disposed inside the package body 10. That is, the electronic component 40 is inside the moisture-proof structure 50, and a circle of the package material of the package body 10 is still disposed outside the moisture-proof structure 50. That is, the moisture-proof structure 50 is still at a specific distance from the peripheral side surface 103 of the package body 10. For example, the moisture-proof structure 50 may be in an embedded form shown in FIG. 2.

In this way, the moisture-proof structure 50 is completely disposed inside the package body 10, so that even if moisture aggregates from the package body 10 disposed outside the moisture-proof structure 50 to the position of the moisture-proof structure 50, the moisture cannot pass through the moisture-proof structure 50 to enter the small gap between the package body 10 and the pin of the electronic component 40 due to the moisture-proof feature of the moisture-proof structure 50. This can effectively prevent a failure of the package substrate 100 due to moisture absorption, and the package substrate 100 has good moisture-proof performance.

In another possible implementation, a part of the moisture-proof structure 50 is exposed outside a side portion of the package body 10. The side portion may be understood as a peripheral side portion of the package body 10, that is, an edge area that is of the package body 10 and that sequentially surrounds four sides.

For example, as shown in FIG. 3, an outer surface of the moisture-proof structure 50 may be exactly exposed, to form the peripheral side surface 103 of the package body 10. Alternatively, a part of the moisture-proof structure 50 may be disposed inside the package body 10, and the other part may be disposed outside the package body 10.

Therefore, on one hand, the moisture-proof structure 50 can hermetically block moisture of an external environment outside the package body 10, and further prevent the moisture of the external environment from entering the package body 10. This helps ensure electrical performance of the package substrate 100. On the other hand, in a production process of the package body 10, a plurality of package bodies 10 may be arranged in an array manner, and two adjacent package bodies 10 may share one moisture-proof structure 50. Therefore, in a subsequent process, the moisture-proof structure 50 of each package body 10 may be partially exposed outside the side portion of the package body 10. This helps save materials and reduce production management costs while ensuring moisture-proof performance, and helps improve production efficiency of the package substrate 100.

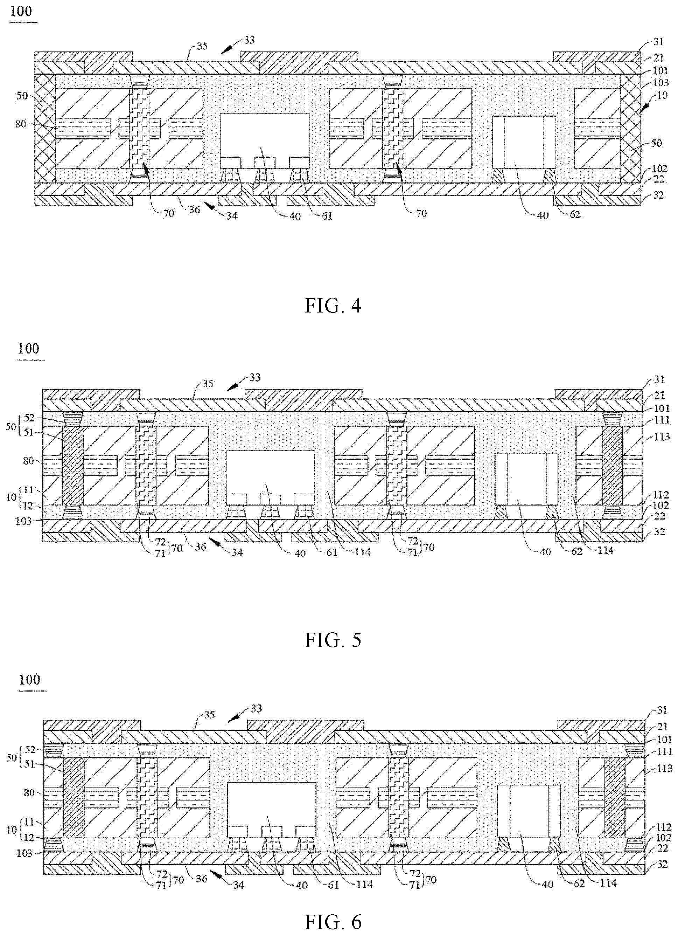

In still another possible implementation, the moisture-proof structure 50 is connected to the peripheral side surface 103 of the package body 10, and is in a structure form in which the moisture-proof structure 50 is completely disposed outside the package body 10. For example, the moisture-proof structure 50 may be in an exposed form shown in FIG. 4.

Therefore, the moisture-proof structure 50 can hermetically block moisture of an external environment outside the package body 10, and further prevent the moisture of the external environment from entering the package body 10. This helps ensure electrical performance of the package substrate 100.

It should be noted that the position of the moisture-proof structure 50 may not be limited to the foregoing described possibilities, provided that the moisture-proof structure 50 can be connected between the first circuit layer 21 and the second circuit layer 22 and surround the electronic component 40. This is not strictly limited in this example of this disclosure.

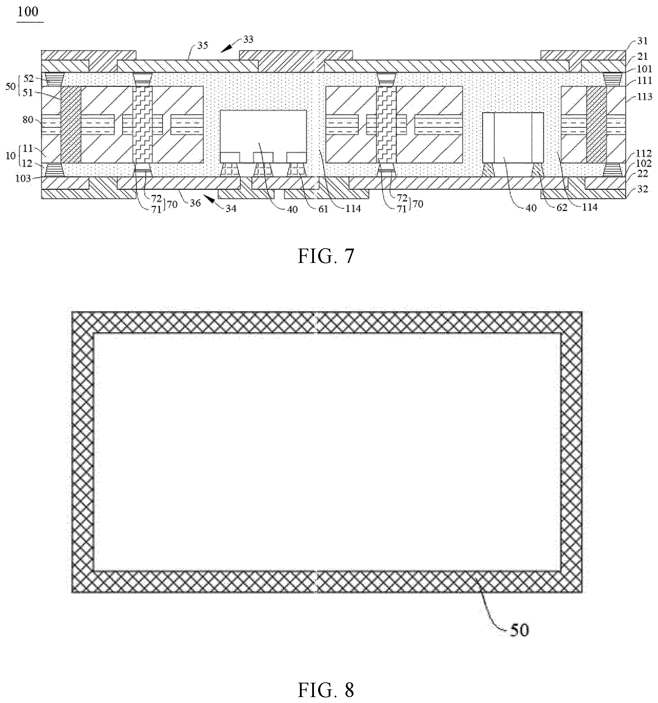

The foregoing describes the possibilities of the position of the moisture-proof structure 50. The following describes possibilities of a structure of the moisture-proof structure 50 with reference to FIG. 8 to FIG. 12.

In a possible implementation, the moisture-proof structure 50 is a continuously-extending closed ring structure.

For example, the moisture-proof structure 50 may be arranged in a four-side closed form shown in FIG. 8. A cross section shown in FIG. 8 is a cross section cut in a direction parallel to the package substrate 100.

In this way, the moisture-proof structure 50 can form a continuous surrounding architecture, and the continuous surrounding architecture can maximize sealing performance of the moisture-proof structure 50, so that external moisture is hermetically blocked outside the continuous surrounding architecture. This helps ensure overall electrical performance of the package substrate 100.

In another possible implementation, the moisture-proof structure 50 includes a plurality of moisture-proof substructures 53, the plurality of moisture-proof substructures 53 are distributed in a staggered manner, and two adjacent moisture-proof substructures 53 at least partially overlap. That is, the plurality of moisture-proof substructures 53 are distributed in the staggered manner inside the peripheral side portion.

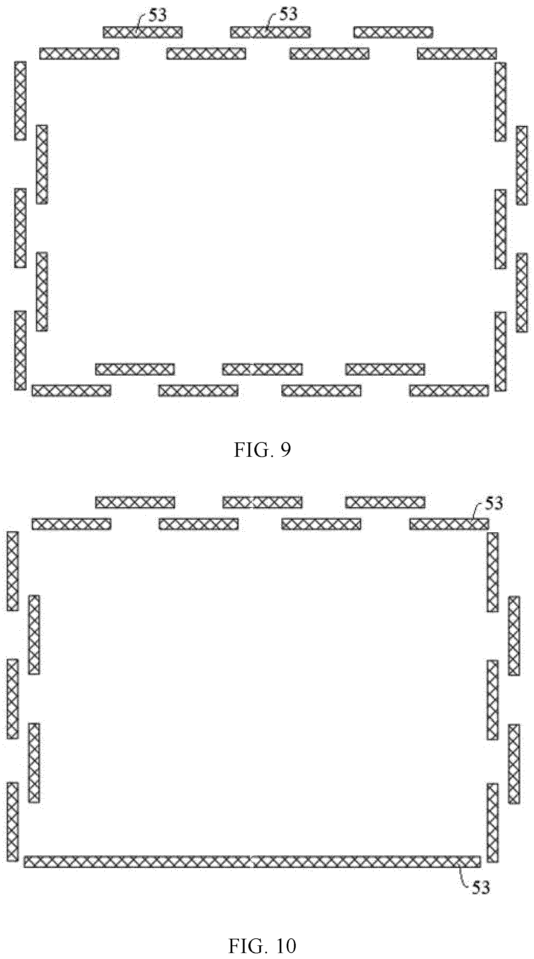

For example, the plurality of moisture-proof substructures 53 may be arranged in a four-side staggered form shown in FIG. 9. A cross section shown in FIG. 9 is a cross section cut in a direction parallel to the package substrate 100. It should be understood that, that two adjacent moisture-proof substructures 53 located on a same side at least partially overlap may be understood as that, on a reference surface parallel to the two adjacent moisture-proof substructures 53, orthographic projection that is of one moisture-proof substructure 53 and that is on the reference surface at least partially falls within a range of orthographic projection that is of the other moisture-proof substructure 53 and that is on the reference surface. That two adjacent moisture-proof substructures 53 at least partially overlap may not only mean that the two adjacent moisture-proof substructures 53 located on a same side at least partially overlap, but also may mean that two adjacent moisture-proof substructures 53 located at a corner at least partially overlap.

In this way, the plurality of moisture-proof substructures 53 can be in a discontinuous surrounding structure, and two adjacent moisture-proof substructures 53 do not have a direct connection relationship, and can be in an arrangement form in which positions are staggered. In addition, the two adjacent moisture-proof substructures 53 at least partially overlap, so that an outer contour surrounded by the plurality of moisture-proof substructures 53 is generally in an annular surrounding form, that is, the plurality of moisture-proof substructures 53 can be in a staggered blocking form. This helps minimize a possibility that external moisture penetrates to cause a failure of the package substrate 100 due to moisture absorption.

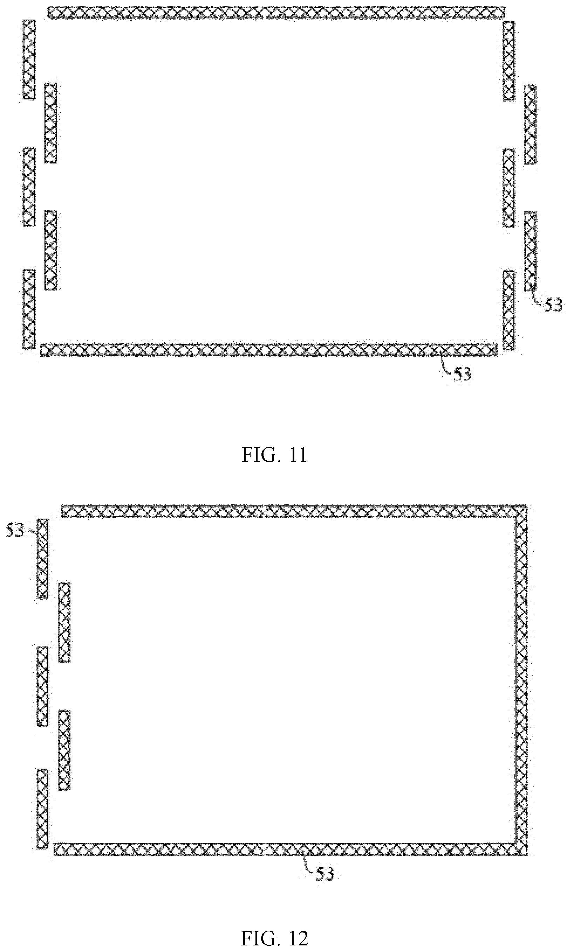

It should be noted that an arrangement form of the plurality of moisture-proof substructures 53 is not limited to the foregoing described possibilities. The arrangement form may alternatively be that one side is continuous and three sides are staggered as shown in FIG. 10, or may be that two sides are continuous and two sides are staggered as shown in FIG. 11, or may be that three sides are continuous and one side is staggered as shown in FIG. 12. Staggered and continuous arrangement and combination forms are not listed herein. However, it should be understood that this example of this disclosure is not limited thereto.

The foregoing describes possibilities of the position and the structure of the moisture-proof structure 50. The following describes in detail structures, positions, and connection forms of the electronic component 40, the first connection column 61, the second connection column 62, the conductive connecting column 70, the moisture-proof structure 50, and the metal layer 80 with reference to a specific structure of the package body 10.

As shown in FIG. 2 to FIG. 7, the package body 10 includes a frame 11 and a package layer 12. The package body 10 is divided into the frame 11 and the package layer 12, so that a structure disposed in the package body 10 can be specifically arranged, to further ensure that the moisture-proof substrate can implement good moisture-proof performance. Details are described below.

The frame 11 includes a first surface 111 and a second surface 112 that are oppositely disposed, and a peripheral side surface 113. The first surface 111, the second surface 112, and the peripheral side surface 113 of the frame 11 jointly form an appearance structure of the frame 11. The frame 11 is further provided with a cavity 114 capable of accommodating the electronic component 40. The cavity 114 is disposed in the frame 11, to implement a packaging form in which the electronic component 40 is embedded in the electronic substrate, so as to improve an arrangement density and integration degree of the package substrate 100.

The frame 11 is made of an insulated resin material. The resin material may be phenolic resin, epoxy resin, bismaleimide-triazine resin, epoxy acrylate, poly propylene glycol (Poly propylene glycol, PPG), epoxy resin containing glass fibers, epoxy acrylate containing glass fibers, or the like.

It should be noted that the cavity 114 may be concavely disposed on the first surface 111, or may be concavely disposed on the second surface 112, or may pass through the first surface 111 and the second surface 112. There may be one, two, or more cavities 114, provided that one cavity 114 correspondingly accommodates one electronic component 40. This is not strictly limited in this example of this disclosure.

It may be understood that the electronic component 40 may be an active electronic component 40 such as a chip (for example, a CPU chip, a radio frequency drive chip, or another processor chip), a diode, or a transistor, or may be a passive electronic component 40 such as a resistor, an inductor, or a capacitor, or may be a combination of at least two of a chip, a diode, a transistor, a resistor, an inductor, and a capacitor.

The electronic component 40 is accommodated in the cavity 114, and is packaged by using the package layer 12. Specifically, the package layer 12 is filled in the cavity 114, to wrap the electronic component 40 and cover the first surface 111 of the frame 11 and the second surface 112 of the frame 11. In this way, the package layer 12 and the frame 11 can jointly form the package body 10. That is, surfaces of the package layer 12 that are away from the frame 11 respectively form the top surface 101 and the bottom surface 102 of the package body 10, and the package layer 12 and the peripheral side surface 113 of the frame 11 jointly form the peripheral side surface 103 of the package body 10.

The package layer 12 is made of an insulated resin material. The resin material may be phenolic resin, epoxy resin, bismaleimide-triazine resin, epoxy acrylate, poly propylene glycol (Poly propylene glycol, PPG), epoxy resin containing glass fibers, epoxy acrylate containing glass fibers, or the like.

In a possible implementation, the package layer 12 is made of a material that is the same as the material of the frame 11, and the cavity 114 is filled with the material that is the same as the material of the frame 11, so that there is a good bonding force between the formed package layer 12 and the frame 11, to improve effect of packaging the electronic component 40.

In another possible implementation, the package layer 12 and the frame 11 may be made of different materials.

It may be understood that, because materials for manufacturing the frame 11 and the package layer 12 have specific moisture absorption performance, the frame 11 and the package layer 12 may absorb external moisture, and as a result, an electric-leakage path is formed at the small gap between the package layer 12 and the pin of the electronic component 40. In this way, the moisture-proof structure 50 is disposed and surrounds the electronic component 40, so that the external moisture can be blocked outside the moisture-proof structure 50, and an electric-leakage path is not easily formed at the small gap between the package layer 12 and the pin of the electronic component 40 due to moisture absorption. This minimizes a possibility that the package substrate 100 is faulty due to formation of the electric-leakage path, and fully ensures high reliability and high stability of the package substrate 100 when the package substrate 100 is powered on for use.

This example of this disclosure is described by using an example in which there are two cavities 114 and two electronic components 40, and the two electronic components 40 are respectively a chip and a resistor-capacitor component (a resistor component or a capacitor component). However, it should be understood that this disclosure is not limited thereto.

Specifically, the chip and the resistor-capacitor component are respectively accommodated in two cavities 114, and are packaged by using the package layer 12 (in FIG. 2 to FIG. 7, the chip is on the left, and the resistor-capacitor component is on the right). The first connection column 61 is sleeved in the package layer 12, and is connected between a pin of the chip and the second circuit layer 22, to connect the chip and the second circuit layer 22. The second connection column 62 is sleeved in the package layer 12, and is connected between a pin of the resistor-capacitor component and the second circuit layer 22, to connect the resistor-capacitor component and the second circuit layer 22.

In other words, the chip may be electrically connected to the second circuit layer 22 by using the first connection column 61, and the resistor-capacitor component may be electrically connected to the second circuit layer 22 by using the second connection column 62. It should be noted that a quantity of first connection columns 61 may be corresponding to a quantity of pins of the chip, and a quantity of second connection columns 62 may be corresponding to a quantity of pins of the resistor-capacitor component. This is not strictly limited in this example of this disclosure.

In this example of this disclosure, the conductive connecting column 70 is located on a periphery of the cavity 114, and is electrically connected between the first circuit layer 21 and the second circuit layer 22. A distance between the conductive connecting column 70 and the peripheral side surface 113 of the frame 11 is greater than a distance between the moisture-proof structure 50 and the frame 11. In other words, the conductive connecting column 70 can connect the first circuit layer 21 and the second circuit layer 22, and the conductive connecting column 70 is within a protection range of the moisture-proof structure 50. That is, the conductive connecting column 70 is located inside the moisture-proof structure 50, and can have good moisture-proof performance due to the protection of the moisture-proof structure 50. This helps better ensure electrical performance of the conductive connecting column 70.

It may be understood that, the electronic component 40 (the chip or the resistor-capacitor component) can be electrically connected to the second circuit layer 22, and the conductive connecting column 70 can form an electrical connection relationship between the first circuit layer 21 and the second circuit layer 22, so that the electronic component 40 can implement double-sided interconnection by using the conductive connecting column 70.

In this way, the conductive connecting column 70 is disposed, so that double-sided interconnection of the electronic component 40 can be implemented. This helps shorten a cabling distance and maximize a short-distance transmission path, can effectively implement higher power with a smaller area or volume, and can improve an overall power density, arrangement density, and integration degree of the package substrate 100.

It may be understood that, the conductive connecting column 70 is not only electrically connected between the first circuit layer 21 and the second circuit layer 22, but also physically connected between the first circuit layer 21 and the second circuit layer 22. In other words, the conductive connecting column 70 is located in the frame 11 and the package layer 12.

Specifically, the conductive connecting column 70 includes a first part 71 and a second part 72. The first part 71 is disposed in the frame 11, and the second part 72 is disposed in the package layer 12 and is connected between the first part 71 and the first circuit layer 21 and connected between the first part 71 and the second circuit layer 22. Specifically, one part of the second part 72 is disposed in the package layer 12 located on the first surface 111 and is connected between one end of the first part 71 and the first circuit layer 21, and the other part of the second part 72 is disposed in the package layer 12 located on the second surface 112 and is connected between the other end of the first part 71 and the second circuit layer 22.

In this way, this can fully ensures that a circuit of the package substrate 100 is sleeved in the frame 11 and the package layer 12, so that the first circuit layer 21 and the second circuit layer 22 can be reliably electrically connected by using a short cabling distance.

For example, the first part 71 and the second part 72 may be manufactured by using different manufacturing processes. For example, the first part 71 may be manufactured by using an addition electroplating process, and the second part 72 may be manufactured by using a microvia filling electroplating process.

It should be noted that a position of the conductive connecting column 70 may be designed based on an actual case, provided that the conductive connecting column 70 is located at the periphery of the cavity 114, can connect the first circuit layer 21 and the second circuit layer 22, and is located inside the moisture-proof structure 50. This is not strictly limited in this example of this disclosure.

As shown in FIG. 5, FIG. 6, and FIG. 7, the moisture-proof structure 50 further includes a frame blocking wall 51 and a package blocking wall 52, and the frame blocking wall 51 is disposed in the frame 11, and the package blocking wall 52 is disposed in the package layer 12. In other words, the frame blocking wall 51 and the package blocking wall 52 jointly form the moisture-proof structure 50, to prevent moisture of the external environment from entering the package body 10.

It may be understood that the frame blocking wall 51 and the package blocking wall 52 jointly form the moisture-proof structure 50. Because the moisture-proof structure 50 has only a moisture-proof function but does not have a function of electrically connecting the first circuit layer 21 and the second circuit layer 22, specific positions of the frame blocking wall 51 and the package blocking wall 52 may be diversified. This disposition can further increase a degree of freedom of manufacturing the moisture-proof structure 50, and help reduce a difficulty of manufacturing the package substrate 100.

The package blocking wall 52 is connected between the frame blocking wall 51 and the first circuit layer 21 and connected between the frame blocking wall 51 and the second circuit layer 22, and orthographic projection that is of the package blocking wall 52 and that is on the first surface 111 at least partially falls within a range of orthographic projection that is of the frame blocking wall 51 and that is on the first surface 111. That is, at least a part of the package blocking wall 52 overlaps the frame blocking wall 51. One part of the package blocking wall 52 is disposed in the package layer 12 located on the first surface 111 and is connected between one end of the frame 11 and the first circuit layer 21, and the other part of the package blocking wall 52 is disposed in the package layer 12 located on the second surface 112 and is connected between the other end of the frame 11 and the second circuit layer 22. For example, the frame blocking wall 51 and the package blocking wall 52 may be in a structure form shown in FIG. 5.

It should be understood that, that the orthographic projection that is of the package blocking wall 52 and that is on the first surface 111 at least partially falls within the range of the orthographic projection that is of the frame blocking wall 51 and that is on the first surface 111 may be: the orthographic projection that is of the package blocking wall 52 and that is on the first surface 111 partially falls within the range of the orthographic projection that is of the frame blocking wall 51 and that is on the first surface 111, or the orthographic projection that is of the package blocking wall 52 and that is on the first surface 111 completely falls within the range of the orthographic projection that is of the frame blocking wall 51 and that is on the first surface 111. The design can be performed based on an actual case. This is not strictly designed.

In another possible implementation, the package blocking wall 52 is connected between the first surface 111 and the first circuit layer 21 and connected between the second surface 112 and the second circuit layer 22, and the package blocking wall 52 and the frame blocking wall 51 are disposed in a staggered manner. In other words, orthographic projection that is of the package blocking wall 52 and that is on the first surface 111 does not overlap orthographic projection that is of the frame blocking wall 51 and that is on the first surface 111. One part of the package blocking wall 52 is disposed in the package layer 12 located on the first surface 111 and is connected between one end of the frame 11 and the first circuit layer 21, and the other part of the package blocking wall 52 is disposed in the package layer 12 located on the second surface 112 and is connected between the other end of the frame 11 and the second circuit layer 22. For example, the frame blocking wall 51 and the package blocking wall 52 may be in a structure form shown in FIG. 6.

In still another possible implementation, the package blocking wall 52 is connected between the first surface 111 and the first circuit layer 21 and connected between the second surface 112 and the second circuit layer 22, and the package blocking wall 52 is adjacent to the frame blocking wall 51. That is, a relationship between the package blocking wall 52 and the frame blocking wall 51 is a critically contact relationship. One part of the package blocking wall 52 is disposed in the package layer 12 located on the first surface 111 and is connected between one end of the frame 11 and the first circuit layer 21, and the other part of the package blocking wall 52 is disposed in the package layer 12 located on the second surface 112 and is connected between the other end of the frame 11 and the second circuit layer 22. For example, the frame blocking wall 51 and the package blocking wall 52 may be in a structure form shown in FIG. 7.

It should be noted that, for possibilities of the position and the arrangement form of the package blocking wall 52 and the frame blocking wall 51, refer to the possibilities of the position and arrangement form of the moisture-proof structure 50 described above. For example, the frame blocking wall 51 may be embedded inside the frame 11, or may be exposed outside a side portion of the frame 11, and the frame blocking wall 51 may be in a continuous ring structure, or may be in a discontinuous surrounding structure. The frame blocking wall 51 may be embedded inside the package layer 12, or may be exposed outside a side portion of the frame 11. The frame blocking wall 51 may be in a continuous ring structure, or may be in a discontinuous surrounding structure. Arrangement and combination forms of the two may be diversified, and details are not described herein again.

Therefore, on one hand, it can be ensured that the moisture-proof structure 50 can be hermetically disposed between the first circuit layer 21 and the second circuit layer 22, to minimize a possibility of a problem that moisture outside the package substrate 100 penetrates from a loose connection position because the moisture-proof structure 50 is not hermetically connected to the first circuit layer 21 and the second circuit layer 22, resulting in a failure of the package substrate 100 due to moisture absorption. On the other hand, because the moisture-proof structure 50 is disposed on each side of the side portion of the package body 10, moisture from various directions can be effectively blocked, to further improve moisture-proof performance of the package substrate 100.

It may be understood that the package blocking wall 52 and the frame blocking wall 51 may be made of a same metal material, or the package blocking wall 52 and the frame blocking wall 51 may be made of different metal materials. The package blocking wall 52 and the frame blocking wall 51 made of metal can further improve mechanical strength of the package body 10. This helps ensure that the package substrate 100 does not easily deform when the package substrate 100 is subject to an external force.

For example, both the package blocking wall 52 and the frame blocking wall 51 may be made of a metal material, for example, copper. The frame blocking wall 51 and the package blocking wall 52 may also be manufactured by using different manufacturing processes. For example, the frame blocking wall 51 may be manufactured by using an addition electroplating process, and the package blocking wall 52 may be manufactured by using a microvia filling electroplating process.

As shown in FIG. 5, the metal layer 80 is embedded in a middle position in a thickness direction of the frame 11, and the metal layer 80 extends along a direction parallel to the package substrate 100. The thickness direction of the frame 11 may be understood as a direction perpendicular to the frame 11, namely, a direction perpendicular to the package body 10, namely, a direction perpendicular to the package substrate 100. It should be understood that the metal layer 80 is not disposed inside the cavity 114.

In this way, one metal layer 80 is added at the middle position in the thickness direction of the frame 11. Due to a structure feature of the metal layer 80, the frame 11 has good heat dissipation performance as a whole, to significantly improve overall heat dissipation performance and stability of the package substrate 100, and mechanical strength of the frame 11 may be increased, so that the frame 11 does not easily deform due to an external force, to improve the mechanical strength of the package substrate 100.

It should be noted that a size that is of the metal layer 80 and that is in the thickness direction of the frame 11 may be designed based on an actual case. Within a range of ensuring overall performance of the frame 11 and processability of the metal layer 80, a larger size that is of the metal layer 80 and that is in the thickness direction of the frame 11 indicates better heat dissipation performance of the frame 11.

In a possible implementation, as shown in FIG. 5, the metal layer 80 intersects with the conductive connecting column 70, and the metal layer 80 is electrically connected to the conductive connecting column 70. For example, the metal layer 80 is perpendicular to the conductive connecting column 70.

It may be understood that the metal layer 80 can be arranged as a circuit layer and provide specific cabling design. In addition, because the metal layer 80 is connected to the conductive connecting column 70 that can implement a double-sided interconnection function, the metal layer 80 may be manufactured as an interconnection circuit according to an actual design requirement, and a signal shield layer between an upper surface and a lower surface (the first surface 111 and the second surface 112) is formed. In this way, the metal layer 80 can improve the heat dissipation performance, improve the mechanical strength, and provide the cabling design, and has diversified performance, high flexibility, and a wide application scope.

It should be noted that, when the metal layer 80 is disposed as the circuit layer, the metal layer 80 may be discontinuously-extending layer structure design, namely, discontinuous layer structure design. The discontinuous structure design can reserve a specific loop for double-sided interconnection, to ensure reliability of double-sided interconnection.

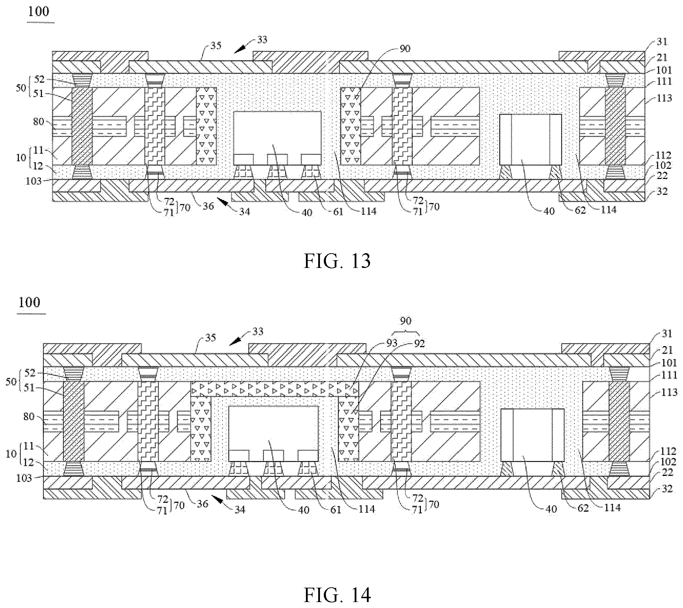

As shown in FIG. 13 and FIG. 14, in this example of this disclosure, the package substrate 100 may further include a signal shielding structure 90 disposed on the frame 11. The signal shielding structure 90 is located between the package blocking wall 52 and the cavity 114 in which the chip is disposed, and surrounds the cavity 114 in which the chip is disposed. A distance between the signal shielding structure 90 and the peripheral side surface 113 of the frame 11 is greater than a distance between the conductive connecting column 70 and the frame 11. In other words, the signal shielding structure 90, the conductive connecting column 70, and the moisture-proof structure 50 are sequentially disposed on a periphery of the cavity 114 in which the chip is disposed. The metal layer 80 may be connected to the signal shielding structure 90, the conductive connecting column 70, and the moisture-proof structure 50.

It may be understood that, the signal shielding structure 90 can be disposed, to avoid signal interference, ensure precision of signal transmission of the chip, and improve stability of the chip during working, so as to minimize a possibility of an exception of the package substrate 100 during working, and fully ensure stability of the package substrate 100 during working.

In a possible implementation, the signal shielding structure 90 is a continuously-extending closed ring structure.

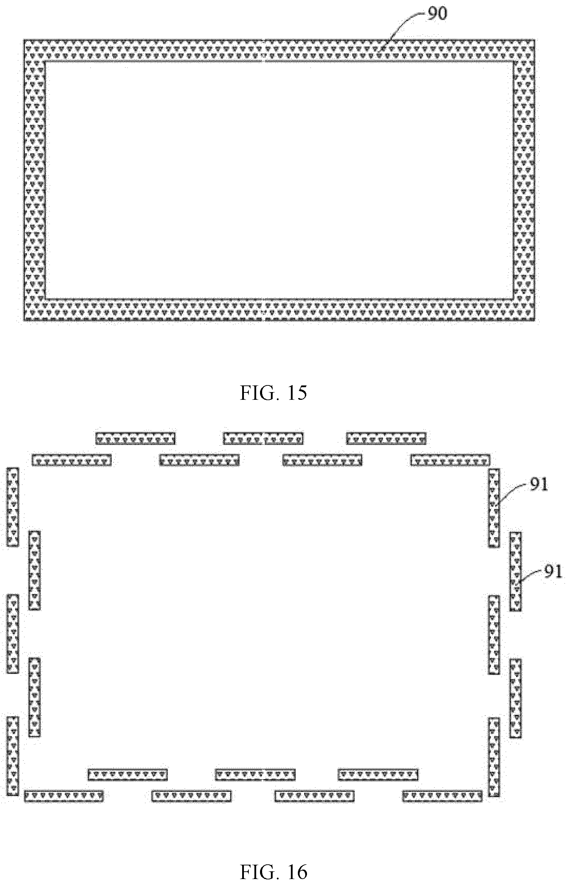

For example, the signal shielding structure 90 may be arranged in a four-side closed form shown in FIG. 15. A cross section shown in FIG. 15 is a cross section cut in a direction parallel to the package substrate 100.

In this way, the signal shielding structure 90 can be disposed around the periphery of the cavity 114 in which the chip is disposed, to form a continuous surrounding architecture. The continuous surrounding architecture can maximize sealing performance of the signal shielding structure 90, and play a good role of shielding signal interference. This helps ensure overall electrical performance of the package substrate 100.

In another possible implementation, the signal shielding structure 90 includes a plurality of signal shielding substructures 91, where the plurality of signal shielding substructures 91 are distributed in the staggered manner inside the peripheral side portion, and two adjacent signal shielding substructures 91 at least partially overlap. That is, the plurality of signal shielding substructures 91 are distributed in the staggered manner inside the peripheral side portion.

For example, the plurality of signal shielding substructures 91 may be arranged in a four-side staggered form shown in FIG. 16. A cross section shown in FIG. 16 is a cross section cut in a direction parallel to the package substrate 100. It should be understood that, that two adjacent signal shielding substructures 91 located on a same side at least partially overlap may be understood as that, on a reference surface parallel to the two adjacent signal shielding substructures 91, orthographic projection that is of one signal shielding substructure 91 and that is on the reference surface at least partially falls within a range of orthographic projection that is of the other signal shielding substructure 91 and that is on the reference surface. That two adjacent signal shielding substructures 91 at least partially overlap may not only mean that the two adjacent signal shielding substructures 91 located on a same side at least partially overlap, but also may mean that two adjacent signal shielding substructures 91 located at a corner at least partially overlap.

In this way, the plurality of signal shielding substructures 91 can be disposed around the periphery of the cavity 114 in which the chip is disposed, to form the discontinuous surrounding structure, and two adjacent signal shielding substructures 91 do not have a direct connection relationship, and can be in an arrangement form in which positions are staggered. In addition, the two adjacent signal shielding substructures 91 at least partially overlap, so that an outer contour surrounded by the plurality of signal shielding substructures 91 is generally in an annular surrounding form, that is, the plurality of signal shielding substructures 91 can be in a staggered blocking form. This helps minimize a possibility that external moisture penetrates to cause a failure of the package substrate 100 due to moisture absorption.

It should be noted that a structure form of the signal shielding structure 90 is not limited to the foregoing described possibilities. The structure form may alternatively be that one side is continuous and three sides are staggered, may be that two sides are continuous and two sides are staggered, or may be that three sides are continuous and one side is staggered. Staggered and continuous arrangement and combination forms are not listed herein. However, it should be understood that this example of this disclosure is not limited thereto.

In still another possible implementation, as shown in FIG. 14, the signal shielding structure 90 includes a shielding blocking wall 92 and a shielding top cover 93. The shielding blocking wall 92 is disposed around a periphery of the cavity 114 in which the chip is disposed, and at least a part of the shielding top cover 93 is located in the cavity 114 in which the chip is disposed, and is connected to one end of the shielding blocking wall 92. It should be understood that the shielding blocking wall 92 may be in a continuously-extending closed ring structure, or may be in a staggered discontinuous surrounding form in the foregoing implementation.

In this way, the signal shielding structure 90 may form a form similar to a lidless box-shaped form. This helps further ensure signal shielding performance of the signal shielding structure 90.

It should be noted that a structure form of the signal shielding structure 90 is not limited to the foregoing described possibilities, and may be a rectangular hexahedron that is embedded in the frame 11 and that wraps the cavity 114 in which the chip is disposed. A hole for the first connection column 61 to pass through is provided only on a surface close to the second circuit layer 22. This is not specifically limited in this example of this disclosure.

## Claims

1. A package substrate (100), comprising:
a package body (10), wherein the package body (10) comprises a top surface (101) and a bottom surface (102) that are oppositely disposed;
a first circuit layer (21) and a second circuit layer (22), wherein the first circuit layer (21) is disposed on the top surface (101) of the package body (10), and the second circuit layer (22) is disposed on the bottom surface (102) of the package body (10);
an electronic component (40), wherein the electronic component (40) is packaged inside the package body (10); and
a moisture-proof structure (50), wherein the moisture-proof structure (50) is embedded in the package body (10), is connected between the first circuit layer (21) and the second circuit layer (22) and has a moisture-proof function, and the moisture-proof structure (50) surrounds the electronic component (40) and is configured to prevent external moisture from a side edge of the package substrate (100) from passing through the moisture-proof structure (50) and penetrating further into the package substrate (100),
wherein
the package body (10) comprises a frame (11) and a package layer (12), each of the frame (11) and the package layer (12) being made of an insulated resin material,
the frame (11) is provided with a cavity (114),
the electronic component (40) is accommodated in the cavity (114),
the frame (11) further comprises a first surface (111) and a second surface (112) that are oppositely disposed,
the package layer (12) is filled in the cavity (114) to wrap the electronic component (40) and covers the first surface (111) and the second surface (112),
surfaces of the package layer (12) that are away from the frame (11) form the top surface (101) and the bottom surface (102),
the moisture-proof structure (50) comprises a frame blocking wall (51) and a package blocking wall (52), the frame blocking wall (51) is disposed in the frame (11), and the package blocking wall (52) is disposed in the package layer (12), the frame blocking wall (51) and the package blocking (52) wall jointly forming the moisture-proof structure (50), and
wherein the package substrate (100) comprises one of additional features i to iii, namely:
i. the package blocking wall (52) is connected between the frame blocking wall (51) and the first circuit layer (21) and connected between the frame blocking wall (51) and the second circuit layer (22), and orthographic projection that is of the package blocking wall (52) and that is on the first surface (111) at least partially falls within a range of orthographic projection that is of the frame blocking wall (51) and that is on the first surface (111); or
ii. the package blocking wall (52) is connected between the first surface (111) and the first circuit layer (21) and connected between the second surface (112) and the second circuit layer (22), and the package blocking wall (52) and the frame blocking wall (51) are disposed in a staggered manner; or
iii. the package blocking wall (52) is connected between the first surface (111) and the first circuit layer (21) and connected between the second surface (112) and the second circuit layer (22), and the package blocking wall (52) is adjacent to the frame blocking wall (51),
**characterized in that** the moisture-proof structure (50) does not have a function of electrically connecting the first circuit layer (21) and the second circuit layer (22).

2. The package substrate (100) according to claim 1, wherein the moisture-proof structure (50) is a continuously-extending closed ring structure.

3. The package substrate (100) according to claim 1, wherein the moisture-proof structure (50) comprises a plurality of moisture-proof substructures (53), the plurality of moisture-proof substructures (53) are distributed in a staggered manner, and two adjacent moisture-proof substructures (53) at least partially overlap.

4. The package substrate (100) according to any of claims 1 to 3, wherein the electronic component (40) is a chip, the package substrate (100) further comprises a signal shielding structure (90) disposed on the frame (11), and the signal shielding structure (90) is located between the package blocking wall (52) and the cavity (114) and surrounds the cavity (114).

5. The package substrate (100) according to claim 4, wherein the signal shielding structure (90) is a continuously-extending closed ring structure.

6. The package substrate (100) according to claim 4, wherein
the signal shielding structure (90) comprises a shielding blocking wall (92) and a shielding top cover (93), the shielding blocking wall (92) is disposed around a periphery of the cavity (114), and at least a part of the shielding top cover (93) is located in the cavity (114) and is connected to one end of the shielding blocking wall (92).

7. The package substrate (100) according to any of claims 1 to 6, wherein the package substrate (100) further comprises a conductive connecting column (70) disposed in the frame (11), and the frame (11) further comprises a peripheral side surface (103) connecting the first surface (111) and the second surface (112); and
the conductive connecting column (70) is located outside the cavity (114), and is electrically connected between the first circuit layer (21) and the second circuit layer (22); and a distance between the conductive connecting column (70) and the peripheral side surface (103) of the frame (11) is greater than a distance between the moisture-proof structure (50) and the peripheral side surface (103) of the frame (11).

8. The package substrate (100) according to any one of claims 1 to 7, wherein the package body (10) further comprises a metal layer (80), the metal layer (80) is embedded in a middle position in a thickness direction of the frame (11), and the metal layer (80) extends along a direction parallel to the package substrate (100).

9. The package substrate (100) according to claim 8 referring to claim 7, wherein the metal layer (80) intersects with the conductive connecting column (70), and the metal layer (80) is electrically connected to the conductive connecting column (70).

10. The package substrate (100) according to claim 1, wherein the package substrate (100) further comprises a first solder mask layer (31) and a second solder mask layer (32);
the first solder mask layer (31) is disposed on a surface that is of the first circuit layer (21) and that is away from the package body (10), and covers a part of the top surface (101) that is of the package body (10) and that is not covered by the first circuit layer (21), the first solder mask layer (31) is provided with a first opening (33), and the first opening (33) exposes a part of the first circuit layer (21), so that the exposed part of the first circuit layer (21) forms a first pad (35) of the package substrate (100); and
the second solder mask layer (32) is disposed on a surface that is of the second circuit layer (22) and that is away from the package body (10), and covers a part of the bottom surface (102) that is of the package body (10) and that is not covered by the second circuit layer (22), the second solder mask layer (32) is provided with a second opening (34), and the second opening (34) exposes a part of the second circuit layer (22), so that the exposed part of the second circuit layer (22) forms a second pad (36) of the package substrate (100).

11. The package substrate (100) according to any one of claims 1 to 10 comprising the additional feature ii, wherein the package blocking wall (52) and the frame blocking wall (51) are made of a metal material.

12. A communication device (200), wherein the communication device (200) comprises a circuit board (210) and the package substrate (100) according to any one of claims 1 to 11, and the package substrate (100) is disposed on the circuit board (210).

## Patentansprüche

1. Gehäusesubstrat (100), Folgendes umfassend:
einen Gehäusekörper (10), wobei der Gehäusekörper (10) eine Oberseite (101) und eine Unterseite (102) umfasst, die gegenüberliegend angeordnet sind;
eine erste Schaltungsschicht (21) und eine zweite Schaltungsschicht (22), wobei die erste Schaltungsschicht (21) auf der Oberseite (101) des Gehäusekörpers (10) angeordnet ist und die zweite Schaltungsschicht (22) auf der Unterseite (102) des Gehäusesubstrats (10) angeordnet ist;
eine elektronische Komponente (40), wobei die elektronische Komponente (40) im Inneren des Gehäusekörpers (10) gehäust ist; und
eine Feuchtigkeitsschutzstruktur (50), wobei die Feuchtigkeitsschutzstruktur (50) in den Gehäusekörper (10) eingebettet ist, zwischen der ersten Schaltungsschicht (21) und der zweiten Schaltungsschicht (22) eingebunden ist und eine Feuchtigkeitsschutzfunktion aufweist, und die Feuchtigkeitsschutzstruktur (50) die elektronische Komponente (40) umgibt und dafür konfiguriert ist zu verhindern, dass externe Feuchtigkeit von einem Seitenrand des Gehäusesubstrats (100) durch die Feuchtigkeitsschutzstruktur (50) gelangt und weiter in das Gehäusesubstrat (100) eindringt, wobei
der Gehäusekörper (10) einen Rahmen (11) und eine Gehäuseschicht (12) umfasst, wobei der Rahmen (11) und die Gehäuseschicht (12) jeweils aus einem isolierenden Harzmaterial bestehen,
der Rahmen (11) mit einem Hohlraum (114) versehen ist,
die elektronische Komponente (40) in dem Hohlraum (114) untergebracht ist,
der Rahmen (11) ferner eine erste Oberfläche (111) und eine zweite Oberfläche (112) umfasst, die einander gegenüberliegen,
die Gehäuseschicht (12) in den Hohlraum (114) gefüllt ist, um die elektronische Komponente (40) zu umhüllen, und die erste Oberfläche (111) und die zweite Oberfläche (112) abdeckt,
Oberflächen der Gehäuseschicht (12), die von dem Rahmen (11) entfernt liegen, die Oberseite (101) und die Unterseite (102) bilden,
die Feuchtigkeitsschutzstruktur (50) eine Rahmensperrwand (51) und eine Gehäusesperrwand (52) umfasst, wobei die Rahmensperrwand (51) in dem Rahmen (11) angeordnet ist und die Gehäusesperrwand (52) in der Gehäuseschicht (12) angeordnet ist, wobei die Rahmensperrwand (51) und die Gehäusesperrwand (52) zusammen die Feuchtigkeitsschutzstruktur (50) bilden, und
wobei das Gehäusesubstrat (100) eines von zusätzlichen Merkmalen i bis iii umfasst, und zwar:
i. die Gehäusesperrwand (52) ist zwischen der Rahmensperrwand (51) und der ersten Schaltungsschicht (21) eingebunden und ist zwischen der Rahmensperrwand (51) und der zweiten Schaltungsschicht (22) eingebunden und eine Orthogonalprojektion von der Gehäusesperrwand (52) und auf die erste Oberfläche (111) fällt zumindest teilweise in einen Bereich einer Orthogonalprojektion von der Rahmensperrwand (51) und auf die erste Oberfläche (111); oder
ii. die Gehäusesperrwand (52) ist zwischen der ersten Oberfläche (111) und der ersten Schaltungsschicht (21) eingebunden und ist zwischen der zweiten Oberfläche (112) und der zweiten Schaltungsschicht (22) eingebunden und die Gehäusesperrwand (52) und die Rahmensperrwand (51) sind in einer gestaffelten Weise angeordnet; oder
iii. die Gehäusesperrwand (52) ist zwischen der ersten Oberfläche (111) und der ersten Schaltungsschicht (21) eingebunden und ist zwischen der zweiten Oberfläche (112) und der zweiten Schaltungsschicht (22) eingebunden und die Gehäusesperrwand (52) grenzt an die Rahmensperrwand (51),
**dadurch gekennzeichnet, dass** die Feuchtigkeitsschutzstruktur (50) keine Funktion des elektrischen Verbindens der ersten Schaltungsschicht (21) und der zweiten Schaltungsschicht (22) aufweist.

2. Gehäusesubstrat (100) nach Anspruch 1, wobei die Feuchtigkeitsschutzstruktur (50) eine sich durchgehend erstreckende geschlossene Ringstruktur ist.

3. Gehäusesubstrat (100) nach Anspruch 1, wobei die Feuchtigkeitsschutzstruktur (50) mehrere Feuchtigkeitsschutzstrukturen (53) umfasst, die mehreren Feuchtigkeitsschutzstrukturen (53) in einer gestaffelten Weise verteilt sind und zwei benachbarte Feuchtigkeitsschutzstrukturen (53) einander zumindest teilweise überlappen.

4. Gehäusesubstrat (100) nach einem der Ansprüche 1 bis 3, wobei die elektronische Komponente (40) ein Chip ist, das Gehäusesubstrat (100) ferner eine Signalabschirmstruktur (90) umfasst, die an dem Rahmen (11) angeordnet ist, und sich die Signalabschirmstruktur (90) zwischen der Gehäusesperrwand (52) und dem Hohlraum (114) befindet und den Hohlraum (114) umgibt.

5. Gehäusesubstrat (100) nach Anspruch 4, wobei die Signalabschirmstruktur (90) eine sich durchgehend erstreckende geschlossene Ringstruktur ist.

6. Gehäusesubstrat (100) nach Anspruch 4, wobei
die Signalabschirmstruktur (90) eine Abschirmungssperrwand (92) und eine obere Abschirmungsabdeckung (93) umfasst, wobei die Abschirmungssperrwand (92) rings um eine Peripherie des Hohlraums (114) angeordnet ist und sich zumindest ein Teil der oberen Abschirmungsabdeckung (93) in dem Hohlraum (114) befindet und mit einem Ende der Abschirmungssperrwand (92) verbunden ist.

7. Gehäusesubstrat (100) nach einem der Ansprüche 1 bis 6, wobei das Gehäusesubstrat (100) ferner eine leitende verbindende Säule (70) umfasst, die in dem Rahmen (11) angeordnet ist, und der Rahmen (11) ferner eine periphere Seitenoberfläche (103) umfasst, welche die erste Oberfläche (111) und die zweite Oberfläche (112) verbindet; und
sich die leitende verbindende Säule (70) außerhalb des Hohlraums (114) befindet und elektrisch zwischen der ersten Schaltungsschicht (21) und der zweiten Schaltungsschicht (22) eingebunden ist; und ein Abstand zwischen der leitenden verbindenden Säule (70) und der peripheren Seitenoberfläche (103) des Rahmens (11) größer als ein Abstand zwischen der Feuchtigkeitsschutzstruktur (50) und der peripheren Seitenoberfläche (103) des Rahmens (11) ist.

8. Gehäusesubstrat (100) nach einem der Ansprüche 1 bis 7, wobei der Gehäusekörper (10) ferner eine Metallschicht (80) umfasst, die Metallschicht (80) an einer in einer Dickenrichtung des Rahmens (11) mittleren Position eingebettet ist und sich die Metallschicht (80) in einer Richtung parallel zum Gehäusesubstrat (100) erstreckt.

9. Gehäusesubstrat (100) nach Anspruch 8, bezugnehmend auf Anspruch 7, wobei die Metallschicht (80) die leitende verbindende Säule (70) schneidet und die Metallschicht (80) elektrisch mit der leitenden verbindenden Säule (70) verbunden ist.

10. Gehäusesubstrat (100) nach Anspruch 1, wobei das Gehäusesubstrat (100) ferner eine erste Lötmaskenschicht (31) und eine zweite Lötmaskenschicht (32) umfasst;
wobei die erste Lötmaskenschicht (31) auf einer Oberfläche angeordnet ist, die zu der ersten Schaltungsschicht (21) gehört und die von dem Gehäusekörper (10) entfernt liegt, und einen Teil der Oberseite (101) abdeckt, der zu dem Gehäusekörper (10) gehört und nicht von der ersten Schaltungsschicht (21) bedeckt ist, wobei die erste Lötmaskenschicht (31) mit einer ersten Öffnung (33) versehen ist und die erste Öffnung (33) einen Teil der ersten Schaltungsschicht (21) freilegt, sodass der freigelegte Teil der ersten Schaltungsschicht (21) ein erstes Pad (35) des Gehäusesubstrats (100) bildet; und
wobei die zweite Lötmaskenschicht (32) auf einer Oberfläche angeordnet ist, die zu der zweiten Schaltungsschicht (22) gehört und die von dem Gehäusekörper (10) entfernt liegt, und einen Teil der Unterseite (102) abdeckt, der zu dem Gehäusekörper (10) gehört und nicht von der zweiten Schaltungsschicht (22) bedeckt ist, wobei die zweite Lötmaskenschicht (32) mit einer zweiten Öffnung (34) versehen ist und die zweite Öffnung (34) einen Teil der zweiten Schaltungsschicht (22) freilegt, sodass der freigelegte Teil der zweiten Schaltungsschicht (22) ein zweites Pad (36) des Gehäusesubstrats (100) bildet.

11. Gehäusesubstrat (100) nach einem der Ansprüche 1 bis 10, das zusätzliche Merkmal ii umfassend, wobei die Gehäusesperrwand (52) und die Rahmensperrwand (51) aus einem Metallmaterial bestehen.

12. Kommunikationsgerät (200), wobei das Kommunikationsgerät (200) eine Leiterplatte (210) und das Gehäusesubstrat (100) nach einem der Ansprüche 1 bis 11 umfasst und das Gehäusesubstrat (100) auf der Leiterplatte (210) angeordnet ist.

## Revendications

1. Substrat de boîtier (100), comprenant :
un corps de boîtier (10), le corps de boîtier (10) comprenant une surface supérieure (101) et une surface inférieure (102) qui sont disposées de manière opposée ;
une première couche de circuit (21) et une deuxième couche de circuit (22), la première couche de circuit (21) étant disposée sur la surface supérieure (101) du corps de boîtier (10), et la deuxième couche de circuit (22) étant disposée sur la surface inférieure (102) du corps de boîtier (10) ;
un composant électronique (40), le composant électronique (40) étant encapsulé à l'intérieur du corps de boîtier (10) ; et
une structure étanche à l'humidité (50), la structure étanche à l'humidité (50) étant intégrée dans le corps de boîtier (10), laquelle étant connectée entre la première couche de circuit (21) et la deuxième couche de circuit (22) et remplissant une fonction d'étanchéité à l'humidité, et la structure étanche à l'humidité (50) entourant le composant électronique (40) et étant configurée pour empêcher l'humidité externe provenant d'un bord latéral du substrat de boîtier (100) de traverser la structure étanche à l'humidité (50) et de pénétrer plus profondément dans le substrat de boîtier (100), où le corps de boîtier (10) comprend un cadre (11) et une couche de boîtier (12), le cadre (11) et la couche de boîtier (12) étant chacun réalisés en un matériau de type résine isolante,
le cadre (11) est muni d'une cavité (114),
le composant électronique (40) est logé dans la cavité (114),
le cadre (11) comprend en outre une première surface (111) et une deuxième surface (112) qui sont disposées de manière opposée,
la couche de boîtier (12) est placée dans la cavité (114) pour envelopper le composant électronique (40) et recouvre la première surface (111) et la deuxième surface (112),
les surfaces de la couche de boîtier (12) qui sont éloignées du cadre (11) forment la surface supérieure (101) et la surface inférieure (102),
la structure étanche à l'humidité (50) comprend une paroi de blocage de cadre (51) et une paroi de blocage de boîtier (52), la paroi de blocage de cadre (51) est disposée dans le cadre (11), et la paroi de blocage de boîtier (52) est disposée dans la couche de boîtier (12), la paroi de blocage de cadre (51) et la paroi de blocage de boîtier (52) formant conjointement la structure étanche à l'humidité (50), et
où le substrat de boîtier (100) comprend l'une des caractéristiques supplémentaires i à iii, à savoir :
i. la paroi de blocage de boîtier (52) est connectée entre la paroi de blocage de cadre (51) et la première couche de circuit (21) et connectée entre la paroi de blocage de cadre (51) et la deuxième couche de circuit (22), et la projection orthogonale de la paroi de blocage de boîtier (52) située sur la première surface (111) tombe au moins partiellement dans une zone de la projection orthogonale de la paroi de blocage de cadre (51) située sur la première surface (111) ; ou
ii. la paroi de blocage de boîtier (52) est connectée entre la première surface (111) et la première couche de circuit (21) et connectée entre la deuxième surface (112) et la deuxième couche de circuit (22), et la paroi de blocage de boîtier (52) et la paroi de blocage de cadre (51) sont disposées de manière décalée ; ou
iii. la paroi de blocage de boîtier (52) est connectée entre la première surface (111) et la première couche de circuit (21) et connectée entre la deuxième surface (112) et la deuxième couche de circuit (22), et la paroi de blocage de boîtier (52) est adjacente à la paroi de blocage de cadre (51),
**caractérisé en ce que** la structure étanche à l'humidité (50) n'a pas pour fonction de connecter électriquement la première couche de circuit (21) et la deuxième couche de circuit (22).

2. Substrat de boîtier (100) selon la revendication 1, dans lequel la structure étanche à l'humidité (50) est une structure annulaire fermée s'étendant de manière continue.

3. Substrat de boîtier (100) selon la revendication 1, dans lequel la structure étanche à l'humidité (50) comprend une pluralité de sous-structures étanches à l'humidité (53), lesdites sous-structures étanches à l'humidité (53) étant réparties de manière décalée, et deux sous-structures étanches à l'humidité (53) adjacentes se chevauchant au moins partiellement.

4. Substrat de boîtier (100) selon l'une quelconque des revendications 1 à 3, dans lequel le composant électronique (40) est une puce, le substrat de boîtier (100) comprend en outre une structure de blindage de signal (90) disposée sur le cadre (11), et la structure de blindage de signal (90) est située entre la paroi de blocage de boîtier (52) et la cavité (114) et entoure la cavité (114).

5. Substrat de boîtier (100) selon la revendication 4, dans lequel la structure de blindage de signal (90) est une structure annulaire fermée s'étendant de manière continue.

6. Substrat de boîtier (100) selon la revendication 4, dans lequel la structure de blindage de signal (90) comprend une paroi de blocage de blindage (92) et un couvercle supérieur de blindage (93), la paroi de blocage de blindage (92) étant disposée autour d'une périphérie de la cavité (114), et au moins une partie du couvercle supérieur de blindage (93) étant située dans la cavité (114) et étant reliée à une extrémité de la paroi de blocage de blindage (92).

7. Substrat de boîtier (100) selon l'une quelconque des revendications 1 à 6, dans lequel le substrat de boîtier (100) comprend en outre une colonne de connexion conductrice (70) disposée dans le cadre (11), et le cadre (11) comprend en outre une surface latérale périphérique (103) reliant la première surface (111) et la deuxième surface (112) ; et la colonne de connexion conductrice (70) est située à l'extérieur de la cavité (114) et est connectée électriquement entre la première couche de circuit (21) et la deuxième couche de circuit (22) ; et la distance entre la colonne de connexion conductrice (70) et la surface latérale périphérique (103) du cadre (11) est supérieure à la distance entre la structure étanche à l'humidité (50) et la surface latérale périphérique (103) du cadre (11).

8. Substrat de boîtier (100) selon l'une quelconque des revendications 1 à 7, dans lequel le corps de boîtier (10) comprend en outre une couche métallique (80), la couche métallique (80) étant encastrée en position médiane dans le sens de l'épaisseur du cadre (11), et la couche métallique (80) s'étendant dans une direction parallèle au substrat de boîtier (100).

9. Substrat de boîtier (100) selon la revendication 8 se référant à la revendication 7, dans lequel la couche métallique (80) croise la colonne de connexion conductrice (70), et la couche métallique (80) est connectée électriquement à la colonne de connexion conductrice (70).

10. Substrat de boîtier (100) selon la revendication 1, dans lequel le substrat de boîtier (100) comprend en outre une première couche de masque de soudure (31) et une deuxième couche de masque de soudure (32) ;
la première couche de masque de soudure (31) est disposée sur une surface de la première couche de circuit (21) qui est éloignée du corps de boîtier (10), et recouvre une partie de la surface supérieure (101) du corps de boîtier (10) qui n'est pas recouverte par la première couche de circuit (21), la première couche de masque de soudure (31) est pourvue d'une première ouverture (33), et la première ouverture (33) expose une partie de la première couche de circuit (21), de sorte que la partie exposée de la première couche de circuit (21) forme un premier plot (35) du substrat de boîtier (100) ; et
la deuxième couche de masque de soudure (32) est disposée sur une surface de la deuxième couche de circuit (22) qui est éloignée du corps de boîtier (10), et recouvre une partie de la surface inférieure (102) du corps de boîtier (10) qui n'est pas recouverte par la deuxième couche de circuit (22), la deuxième couche de masque de soudure (32) est pourvue d'une deuxième ouverture (34), et la deuxième ouverture (34) expose une partie de la deuxième couche de circuit (22), de sorte que la partie exposée de la deuxième couche de circuit (22) forme un deuxième plot (36) du substrat de boîtier (100).

11. Substrat de boîtier (100) selon l'une quelconque des revendications 1 à 10, comprenant la caractéristique supplémentaire ii, où la paroi de blocage de boîtier (52) et la paroi de blocage de cadre (51) sont réalisées en matériau métallique.

12. Dispositif de communication (200), le dispositif de communication (200) comprenant une carte de circuit imprimé (210) et le substrat de boîtier (100) selon l'une quelconque des revendications 1 à 11, et le substrat de boîtier (100) étant disposé sur la carte de circuit imprimé (210).
